# EUROPÄISCHE PATENTSCHRIFT

(11) **EP 1 856 436 B1**
(45) Veröffentlichungstag und Bekanntmachung des Hinweises auf die Patenterteilung: **06.10.2010**
(21) Anmeldenummer: 06707524.2
(22) Anmeldetag: 10.03.2006
(51) Int. Cl.: F16L 37/248, B01J 4/00

(54) **GASDICHTES VERBINDUNGSELEMENT MIT BAJONETTVERSCHLUSS**
GAS-TIGHT CONNECTING ELEMENT COMPRISING A BAYONET CLOSURE
ELEMENT DE LIAISON ETANCHE AUX GAZ, A FERMETURE A BAIONNETTE

(30) Priorität: 11.03.2005 DE 102005011384
(43) Veröffentlichungstag der Anmeldung: 21.11.2007
(73) Patentinhaber: centrotherm thermal solutions GmbH + Co. KG, 89143 Blaubeuren (DE)
(72) Erfinder: HARTUNG, Robert, Michael, 89143 Blaubeuren-Seissen (DE); KELLER, Andreas, 89614 Öpfingen (DE)
(74) Vertreter: Lippert, Stachow & Partner
(86) Internationale Anmeldenummer: PCT/EP2006/002232
(87) Internationale Veröffentlichungsnummer: WO 2006/094824

(56) Entgegenhaltungen:
- DE-A- 19 727 346
- DE-A- 19 727 346
- DE-A1- 19 633 713
- DE-C- 378 601
- DE-C- 378 601
- US-A- 4 624 489
- US-A- 5 526 984
- US-A1- 2003 177 977
- US-A1- 2004 216 668

## Beschreibung

Die Erfindung betrifft eine gasdichte Durchführung für ein Prozessrohr in eine innerhalb des Prozessrohres befindliche Prozesskammer zur Zu- oder Ableitung von Prozessgasen, umfassend eine damit verbundene insbesondere sich zumindest teilweise längs des Prozessrohrs innerhalb der Prozesskammer erstreckende Gaslanze, ein Leitungsrohr und ein Verbindungselement, welches an dem Leitungsrohr und an der Gaslanze befestigbar ist, wobei das Verbindungselement mit der Gaslanze und dem Leitungsrohr jeweils formschlüssig und gasdicht verbunden ist und für einen Kraftschluss zwischen Gaslanze, Verbindungselement und Leitungsrohr sorgt.

Eine derartige gasdichte Durchführung ist aus dem Dokument US 5 526 984 bekannt.

Der Transport bzw. die Führung gasförmiger Medien stellt häufig besondere Anforderungen an die hierbei eingesetzten Bauteile. Besonders in solchen Fällen, die unter außergewöhnlichen äußeren Bedingungen erfolgen, beispielsweise unter erhöhten Temperaturen, oder bei Verbindungen mit hoher Reaktivität gegenüber Materialien wie Metall oder Kunststoff, können zum Transport oder zur Führung oft nur Materialien eingesetzt werden, deren Handhabung unter Prozessbedingungen oft umständlich ist. Bei der Herstellung von Halbleiterbauelementen werden beispielsweise häufig Prozessrohre eingesetzt, in denen so genannte Wafer mit Prozessgasen beaufschlagt werden, die üblicherweise mit Hilfe einer längs in den Prozessraum erstreckenden Gaslanze zu- und abgeführt werden. Die Erfindung soll eine Gasverbindung zwischen dem Inneren des Prozessrohrs und außen bereitstellen, wobei die Durchführung auch unter den bei CVD-Techniken üblichen hohen Temperaturen eine hohe Gasdichtigkeit aufweist.

Bei der Fertigung von Halbleiterbauelementen sind in vielen Fällen Hochtemperaturprozesse notwendig, um verschiedene Prozessschritte, z.B. das Abscheiden von Schichten, durchzuführen.

Beispielsweise ist es für die Herstellung von Halbleiterbauelementen notwendig, auf den hierfür verwendeten Halbleiterscheiben die entsprechenden Halbleiterstrukturen auszubilden. Dies erfolgt in der Regel durch die Abscheidung von Schichten auf den Halbleiterscheiben, sowie anschließende Belichtungs-, bzw. Strukturierungs- und Ätzprozesse, die mit entsprechenden Prozessgasen durchgeführt werden. Die Beschichtungs- und Ätzprozesse werden dabei in so genannten Prozessrohren durchgeführt, in denen sich die Hableiterscheiben während dieser Prozesse befinden. Diese Prozessrohre stellen einerseits einen Reaktionsraum zur Verfügung, der auch unter den bei Reaktionsbedingungen oft herrschenden hohen Temperaturen Stabilität zeigt. Die Prozessrohre sollen jedoch auch sicherstellen, dass keine Stoffe aus der Umgebung Zutritt zum Reaktionsraum erhalten. Aus diesem Grund werden als Materialien für Prozessrohre oft Quarz- oder Siliziumcarbidrohre eingesetzt, die einerseits eine sehr hohe Temperaturbelastbarkeit aufweisen und andererseits eine Kontamination der Prozessgase mit unerwünschten Stoffen in ausreichender Weise verhindern.

Ein häufig durchzuführender Prozessschritt bei der Fertigung von Halbleiterelementen ist die Erzeugung von Siliziumoxid als elektrische Isolationsschicht zwischen den verschiedenen Lagen aus elektrisch leitfähigen Komponenten. Insbesondere bei der Herstellung von Feldeffekt-Transistoren (FET) hat die Isolationsschicht einen großen Einfluss auf die Güte der elektrischen Eigenschaften des elektronischen Bauelements und minimale Abweichungen der Schichtdicke des Siliziumoxids können zu einer Beeinträchtigung der elektrischen Funktion führen.

Aus dem Stand der Technik sind verschiedene Verfahren bekannt, wie Siliziumoxid auf einen Wafer aufgebracht werden kann. Beispielsweise kann der Wafer mit Wasserdampf beaufschlagt werden. Dazu kann reines Wasser verdampft oder, wie in der US 6,733,732 offenbart, mit Hilfe eines Katalysators in einem Reaktor erzeugt werden.

In einem weiteren aus dem Stand der Technik bekannten Verfahren wird Wasser in einer kontrollierten Verbrennung von Sauerstoff und Wasserstoff kurz vor dem Aufdampfprozess hergestellt. Dieses Verfahren hat den Vorteil, dass der Feuchtegrad des Wasserdampfes besser reguliert werden kann. Dabei wird in der Nähe des Prozessrohrs und außerhalb der Prozesskammer Wasserstoff und Sauerstoff mit einem Brenner, beispielsweise einem sog. Hydrox, bei hohen Temperaturen verbrannt. Zum Bau eines Brenners wird bevorzugt Quarz verwendet, um den hohen Temperaturen bei der Verbrennung widerstehen zu können. Damit das Wasser nicht vorzeitig kondensiert, wird der Brenner zweckmäßigerweise in der unmittelbaren Nähe des Prozessrohrs angeordnet, um weite Transportwege für den Wasserdampf zu vermeiden. Der heiße Wasserdampf wird dann an einer geeigneten Stelle in den Reaktionsraum im Inneren des Prozessrohrs eingeleitet, wozu eine hitzebeständige gasdichte Durchführung benötigt wird.

Die oben genannten Anforderungen an die Prozessrohre bzw. die mit diesen verbundenen Leitungselementen betreffen jedoch nicht nur die Erzeugung von Isolierschichten sondern auch bei vielen anderen, mit der Abscheidung von Stoffen aus der Gasphase bei erhöhter Temperatur verbundenen Prozessen. Bei der Herstellung von Halbleiterschaltkreisen ist es beispielsweise notwendig, zunächst geeignete Strukturen auf Halbleiterscheiben zu erzeugen, was in der Regel durch einander abwechselnde Strukturierungs-, Beschichtungs- und Ätzschritte erfolgt. Diese Beschichtungs- und Ätzschritte werden üblicherweise in Prozesskammern durchgeführt, die gegenüber der Umwelt abgeschirmt sind. Da einerseits hohe Prozesstemperaturen benötigt werden und andererseits verhindert werden muss, dass den Prozessgasen unkontrolliert fremde Stoffe beigemischt werden, hat sich die Verwendung von rohrförmigen Prozessreaktoren aus Quarz oder Siliziumcarbid hierfür als besonders geeignet erwiesen. Die Prozesstemperaturen können dabei in einem Bereich von 400°C bis 1300°C, beispielsweise in einem Bereich von etwa 550 bis etwa 1250°C oder etwa 700 bis etwa 1200°C oder insbesondere in einem Bereich von etwa 900°C bis etwa 1100°C, liegen.

Im Interesse einer einfachen Beschickung dieser Prozessrohre mit einer Vielzahl von übereinander angeordneten Halbleiterscheiben werden die Prozessrohre bevorzugt vertikal in eine entsprechende Anlage eingesetzt.

Um alle im Prozessrohr in der Prozesskammer befindlichen Halbleiterscheiben möglichst gleichmäßig zu behandeln, ist es notwendig, innerhalb der Prozesskammer einen Gasstrom längs der Prozesskammer zu erzeugen, so dass an allen darin befindlichen Halbleiterscheiben während des Behandlungsvorganges die im Wesentlichen gleiche Gasmenge vorbeistreicht. Um dies zu erreichen, werden beispielsweise der Gaseinlass an einem Ende des Prozessrohrs und der Gasauslass am gegenüberliegenden anderen Ende des Prozessrohrs angeordnet.

Wegen der Verwendung von mitunter toxischen Gasen sollte am Gaseinlass und am Gasauslass des Prozessrohrs gewährleistet werden, dass gegenüber der Umwelt ein möglichst gasdichter Anschluss erreicht wird. Hierfür ansonsten übliche Verschraubungen mit Quetschdichtungen sind aus den verschiedensten Gründen problematisch. Solche Gründe sind beispielsweise die mögliche Kontamination der Prozessgase mit unerwünschten Fremdstoffen und das Entstehen von Undichtigkeiten in Folge unterschiedlicher Ausdehnungskoeffizienten. Aus diesem Grund werden für die Anordnung der Gasanschlüsse innerhalb des Prozessrohrs oft Gaslanzen verwendet, die längs in das Prozessrohr eingeschoben und dort räumlich fixiert werden. Durch diese Gaslanze kann damit am jeweils gegenüberliegenden Ende der Prozesskammer innerhalb des Prozessrohrs Gas eingeblasen bzw. abgesaugt werden. Das Prozessgas, beispielsweise Wasserdampf, wird daher meist durch einen kurzen Injektor in den Prozessraum geführt, wo er verwirbelt und auf allen Wafern möglichst gleichmäßig die gewünschte Oxidation bewirkt. Die Gaslanzen werden in Anhängigkeit vom Einsatzzweck üblicherweise ebenfalls aus Materialien gefertigt, die unter den herrschenden Prozessbedingungen möglichst stabil und inert sind, beispielsweise aus Glas oder Siliziumcarbid.

Aus Platzgründen muss die Gaslanze jedoch oft abgewinkelt geführt werden. Wird die Gaslanze beispielsweise zentral in den rohrförmigen Reaktor eingeführt, muss sie aufgrund der Position der Wafer abgewinkelt werden um dann an der Reaktorwand weitergeführt zu werden. Die Einarbeitung einer solchen Gasführung bei der Herstellung des Reaktors ist sehr aufwendig und teuer. Außerdem ist dann eine solche Gasführung fest integriert und ermöglicht keine Wartung bzw. keinen Austausch der Lanze. Während ungewinkelte Lanzen ohne Schwierigkeiten in das Prozessrohr eingeführt werden können, ist dieses bei gewinkelten Lanzen nicht mehr ohne weiteres möglich und muss daher üblicherweise über die Beschickungsöffnung des Reaktors erfolgen.

Die Befestigung der Gaslanze und ihre gasdichte Durchführung stellen aufgrund der thermischen Belastung des Reaktors eine besondere Schwierigkeit dar. Prinzipiell besteht zwar die Möglichkeit, die Gaslanze von oben in das Prozessrohr einzuführen und durch Schliffe oder Quetschverschraubungen abzudichten. Der Nachteil dieser Variante ist darin zu sehen, dass die Montage der Gaslanze von oben erfolgen muss, wobei bereits das Einfädeln problematisch ist und zusätzlich eine zuverlässige und dauerhafte Abdichtung kaum erreicht werden kann. Außerdem führen die zum Abdichten erforderlichen Materialien zu den bereits beschriebenen Schwierigkeiten. Darüber hinaus ist die an sich gewünschte gleichmäßige Isolierung des Prozessrohrs nicht möglich, da ein Freiraum freigehalten werden muss, durch den die Gaslanze in das Prozessrohr geschoben werden kann.

Diese mit der Durchführung verbundenen Probleme werden gemäß der DE 197 27 346 A1 dadurch gelöst, dass die Gaslanze mit einem Anschlussstutzen versehen ist, der in axialer Anordnung durch eine Öffnung im Prozessrohr greifend, kraftschlüssig und gasdicht mit einem Gaseinlass/Auslasszwischenrohr außerhalb des Prozessrohrs in Verbindung steht, wobei ein mit einem Haken versehener Haltestab vorgesehen ist, der sich axial durch den Stutzen der Gaslanze, den Anschlussstutzen und das Gaseilass/Auslasszwischenrohr erstreckt, wobei der Haken an der Innenwand des Prozessrohrs verhakt ist und das andere Ende des Haltestabes gasdicht durch das Gaseinlass-/Auslasszwischenrohr nach außen geführt ist. Wünschenswert ist jedoch, dass die Durchführung einfacher zu montieren ist.

DE 378 601 offenbart ein Verbindungsstück zwischen einem Gaszuführungsrohr und einem Verbrauchsapparat, die mit einem Bajonettverschluss verbunden sind.

Die US 5 526 984 A beschreibt einen Wasserstoffbrenner mit einer gasdichten Durchführung für ein Prozessrohr in eine innerhalb des Prozessrohrs befindliche Prozesskammer zur Zuführung von Prozessgasen mit einer Gaslanze, welche in das Prozessrohr hineinragt. An der Gaslanze sind Leitungsrohre und ein Verbindungselement befestigt, wobei die Gaslanze mit den Leitungsrohren formschlüssig und gasdicht verbunden ist und wobei das Verbindungselement für einen Kraftschluss zwischen der Gaslanze und den Leitungsrohren sorgt.

Damit war es Aufgabe der vorliegenden Erfindung, eine Vorrichtung zur Führung oder zum Transport gasförmiger Medien zur Verfügung zu stellen, die auch bei anspruchsvollen Materialien, beispielsweise bei brüchigen Materialien wie Glas oder Siliziumcarbid, einfach zu handhaben ist. Weiterhin lag eine Aufgabe der vorliegenden Erfindung in der Bereitstellung einer gasdichten Verbindung, die den Transport oder die Führung gasförmiger Medien bei anspruchsvollen Materialien oder bei anspruchsvollen Geometrien der Transportvorrichtung erleichtert und verbessert. Eine weitere Aufgabe der Erfindung lag in der Bereitstellung einer Durchführung, eines Leitungsrohrs bzw. einer Gaslanze für eine Anlage zum Abscheiden von Stoffen aus der Gasphase, beispielsweise eine CVD-Anlage, womit der Bedampfungsprozess zuverlässig und auf einfache Weise beherrscht werden kann und ein hohes Maß an Gasdichtheit der Durchführung und der Prozesskammer sichergestellt wird.

Gemäß Anspruch 1 wird diese Aufgabe erfindungsgemäß bei einem gasdichten Verbindungselement der eingangs genannten Art gelöst, indem die Gaslanze oder das Verbindungselement einen Vorsprung, vorzugsweise einen Stift, aufweist und wobei das Verbindungselement bzw. die Gaslanze entsprechend hierzu eine Aufnahme, vorzugsweise eine Führungsnut oder einen Schlitz mit Gewindesteigung, aufweist, so dass die Gaslanze mit dem Verbindungselement und mit dem Leitungsrohr durch eine Drehbewegung des Verbindungselementes, der Gaslanze und/oder des Leitungsrohres verbindbar sind.

Die Erfindung betrifft daher eine Vorrichtung zur Führung oder zum Transport gasförmiger Medien, umfassend mindestens ein zwei Verbindungsstücke aufweisendes Verbindungselement, welches zum Verbinden gasführender Medien geeignet ist, wobei eines der Verbindungsstücke des Verbindungselementes einen Vorsprung, vorzugsweise einen Stift, aufweist und das andere Verbindungsstück des Verbindungselements entsprechend hierzu eine Aufnahme, vorzugsweise eine Führungsnut oder einen Schlitz, aufweist.

Im Rahmen des vorliegenden Textes wird aus praktischen Erwägungen das erfindungsgemäße Konzept der Vorrichtung zur Führung oder zum Transport gasförmiger Medien anhand eines Ausführungs beispiel einer gasdichten Durchführung für ein Prozessrohr in eine innerhalb des Prozessrohrs befindliche Prozesskammer zur Zu- oder Ableitung von Prozessgasen näher erläutert.

Mit Hilfe der erfindungsgemäßen Durchführung wird vorteilhafterweise eine hohe Dichtigkeit selbst unter den hohen thermischen Belastungen eines Prozessrohrs mit Temperaturen in einem Bereich von 400°C bis 1300°C, beispielsweise in einem Bereich von etwa 550 bis etwa 1250°C oder etwa 700 bis etwa 1200°C oder insbesondere in einem Bereich von etwa 900°C bis etwa 1100°C, erzielt.

Dies ist von besonderem Vorteil, wenn das Prozessrohr für eine chemische Bedampfung, beispielsweise im Rahmen von CVD Prozessen oder Diffusionsprozessen, eingesetzt werden soll. Mit Hilfe der Gaslanze kann Prozessgas, beispielsweise Wasserdampf, der Prozesskammer zugeführt werden, wo das Prozessgas mit einem Werkstück, insbesondere einem Wafer, wechselwirkt. Beispielsweise kann die Oberfläche eines Wafers durch das Aufbringen von Wasserdampf passiviert und chemisch isoliert werden, indem eine Siliziumoxidschicht gebildet wird. Die Gaslanze ist vorzugsweise aus Quarz oder Siliziumcarbid gefertigt und verfügt über geeignete Bohrungen, aus denen das Prozessgas austreten kann. Die Gaslanze ist vorteilhafterweise an ihrem freien Ende geschlossen. Das Prozessgas kann heißer Wasserdampf sein. Grundsätzlich können hier jedoch auch alle üblichen, bei CVD Prozessen verwendeten Prozessgase eingesetzt werden.

Durch die gasdichte Durchführung kann beispielsweise eine fluidleitende Verbindung für das Prozessgas von außen in die Prozesskammer hergestellt werden, wobei das Prozessgas durch das Leitungsrohr und die Gaslanze geführt wird. Damit stellt die gasdichte Durchführung eine ausreichende Dichtigkeit für das Prozessgas zwischen dem Leitungsrohr und der Gaslanze her. Darüber hinaus sorgt die gasdichte Durchführung für eine weitgehende Abdichtung der Prozesskammer von bzw. nach außen, so dass im Wesentlichen weder Gas in die Prozesskammer eindringen kann noch Gas aus der Prozesskammer nach außen gelangen kann. Mit Hilfe der gasdichten Durchführung kann im Inneren der Prozesskammer beispielsweise Umgebungsdruck gehalten werden. Es ist jedoch ebenso möglich, mit der erfindungsgemäßen gasdichten Durchführung kann im Inneren der Prozesskammer mit Unterdruck oder Überdruck zu arbeiten. Geeignet sind beispielsweise Drücke, die in einem Bereich von etwa 300 mbar, beispielsweise etwa 200 mbar oder etwa 100 mbar oder etwa 50 mbar um den Umgebungsdruck liegen. Es ist jedoch ebenso möglich eine erfindungsgemäße Vorrichtung niedrigeren Drücken einzusetzen, beispielsweise bei einem Druck von weniger als 10⁻³ bar oder weniger als 10⁻⁶ bar oder weniger als 10⁻⁷ bar. Auch kann beispielsweise die erfindungsgemäße Vorrichtung bei einem Überdruck von bis zu etwa 0,1 bar, oder bis zu etwa 0,3 bar, oder bis zu etwa 1 bar, eingesetzt werden.

Vorteilhafterweise sind die Elemente zur formschlüssigen Verbindung zwischen den Transportvorrichtungen zur Führung oder zum Transport gasförmiger Medien zwischen dem Verbindungselement und der Gaslanze sowie zwischen dem Verbindungselement und dem Leitungsrohr aus Materialien mit gleichen oder ähnlichen thermischen Ausdehnungskoeffizienten beispielsweise aus gleichem bzw. aus ähnlichem Material gefertigt, so dass keine außerhalb eines gegebenenfalls bestehenden Toleranzbereichs liegende Gasundichtigkeit der Durchführung aufgrund einer unterschiedlichen thermischen Ausdehnung resultiert. Im Gegensatz zu herkömmlichen Quetschverbindungen wird die Gasdichtigkeit der gasdichten Durchführung durch eine Kombination von Formschluss und Kraftschluss bewirkt.

Während in einer nicht erfindungsgemäßen Ausgestaltung die Gaslanze direkt mit dem Leitungsrohr formschlüssig verbunden ist, erfolgt der Formschluss erfindungsgemäß über das Verbindungselement, d.h. die Gaslanze wird formschlüssig mit dem Verbindungselement verbunden, welches wiederum formschlüssig mit dem Leitungsrohr verbunden wird. Das Verbindungselement sorgt für einen Kraftschluss für die gasdichte Durchführung. Hierzu greift das Verbindungselement sowohl an der Gaslanze wie auch an dem Leitungsrohr an, wozu an der Gaslanze, dem Verbindungselement und dem Leitungsrohr entsprechende Vorsprünge bzw. Aufnahmen vorgesehen sind.

Kraftschlüssige Verbindungen entstehen durch die Übertragung von Kräften. Dazu zählen z.B. Druckkräfte oder Reibungskräfte. Der Zusammenhalt der kraftschlüssigen Verbindung wird im Wesentlichen durch die wirkende Kraft gewährleistet. Zugkräfte können mit kraftschlüssigen Verbindungen in der Regel nicht übertragen werden, da sich beide Verbindungspartner voneinander lösen würden. Die Gaslanze und das Leitungsrohr sollen gasdicht verbunden werden, welches durch Formschluss bewirkt wird. Hierfür werden die Kontaktflächen der Gaslanze und Leitungsrohrs komplementär bzw. invers zueinander ausgestaltet. Durch eine möglichst passgenaue Verbindung der ineinander greifenden und aneinander anschmiegenden Verbindungspartner wird ein hohes Maß an Gasdichtigkeit bewirkt.

Die Gaslanze, das Verbindungselement und/oder das Leitungsrohr bestehen vorteilhafterweise aus einem rohrförmigen Abschnitt aus hitzebeständigem Material. Das Verbindungselement weist eine Dichtungsfläche auf, die so gestaltet ist, dass sie passgenau an den Prozessrohr angeschlossen werden und diesen abdichten kann. Die Dichtungsfläche wird vorteilhafterweise gewölbt oder mit einer Konusform ausgebildet. Beispielsweise weist die Dichtungsfläche eine Kugelflächenform oder Schalenflächenform auf. Die Dichtungsfläche bildet mit einer entsprechenden Gegenfläche am Prozessrohr eine gasdichte Verbindung.

Während Wafern bis zu einem Durchmesser von 150 mm eine kurze Gaslanze oft ausreicht, um ein Prozessgas in die Prozesskammer einzuleiten, kann es vorteilhaft sein, bei größeren Wafern und damit größeren Reaktoren das Prozessgas an mehreren Stellen einzuleiten, da aufgrund der Größe der Wafer und damit aufgrund der Größe der Prozesskammer eine kurze Gaslanze zu einer Inhomogenität in der Prozessgaskonzentration in der Prozesskammer führen kann. Beispielsweise bedingt eine Konzentrationsinhomogenität des Wasserdampfs eine entsprechende Schwankung der Oxidschichtdicke, wodurch sich die Qualität der so erzeugten Oxidschichten verschlechtert. Um der inhomogenen Verteilung des Wasserdampf in der Prozesskammer entgegenzuwirken, wird der Wasserdampf vorteilhafterweise mit Hilfe der Gaslanze an vielen verschiedenen Stellen im Reaktor eingeleitet, wofür die Gaslanze eine Vielzahl von Öffnungen aufweist, durch die der Wasserdampf in die verschiedenen Raumbereiche des Reaktors austreten kann.

Vorteilhafterweise kann das Verbindungselement mit einer weiteren Dichtungsfläche gegenüber einem Mittel zur Bereitstellung des Prozessgases, insbesondere mit einem Verdampfer, z.B. einem Hydrox, verbunden werden. An der formschlüssigen Verbindung wird aufgrund des Kraftschlusses ein Auflagedruck zwischen den gegeneinander dichtenden Flächen erzeigt, der eine für den angestrebten Zweck, insbesondere für die angestrebten Druckverhältnisse ausreichenden Flächendruck erzeugt. Geeignet sind beispielsweise Flächendrücke von mindestens etwa 10⁴ Pa/m² oder mindestens etwa 10⁵ Pa/m² oder mindestens etwa 10⁶ Pa/m².

Bei einer Ausgestaltung der Erfindung ist mindestens ein Element aus der Gruppe Gaslanze, Leitungsrohr und Verbindungselement aus einem hitzebeständigen Material, insbesondere Glas, Keramik, Quarz, Siliziumcarbid gefertigt. Hierdurch soll insbesondere sichergestellt werden, dass eine Gasdichtigkeit auch bei Temperaturen von 400°C bis 1300°C, beispielsweise von etwa 550 bis etwa 1250°C oder etwa 700 bis etwa 1200°C oder insbesondere von etwa 900°C bis etwa 1100°C, gewährleistet ist.

Es weist im Rahmen einer bevorzugten Ausführungsform der vorliegenden Erfindung beispielsweise mindestens ein Element aus der Gruppe Gaslanze, Leitungsrohr und Verbindungselement einen Dichtungsschliff, insbesondere einen Kugel- oder Kegelschliff, auf. Geeignet sind hier beispielsweise Kugel- oder Kegelschliffe deren Rauhigkeit (Unebenheit des Dichtungsschliffs) den Werten eines Standarddichtungsschliffs entspricht. Unebenheiten des Dichtungsschliffes betragen vorteilhafterweise etwa 2 µm oder weniger, beispielsweise 1 µm oder weniger und können in besonderen Fällen auch kleiner als 500 nm, insbesondere kleiner als 200 nm oder kleiner als 100 Nanometer sein.

Erfindungsgemäß weist die Gaslanze oder das Verbindungselement einen Vorsprung, beispielsweise einen Stift auf. Das Verbindungselement bzw. die Gaslanze weist entsprechend hierzu zweckmäßigerweise eine Aufnahme, vorzugsweise eine Führungsnut oder einen Schlitz auf. Der Stift wird vorteilhafterweise in eine Bohrung an der Gaslanze bzw. an dem Verbindungselement angebracht. Die Bohrung an der Gaslanze wird dann vorteilhafterweise als Sackloch ausgebildet, so dass ein Austreten von Gas durch einen Spalt zwischen der Innenfläche der Bohrung und der Außenfläche des Stiftes vermieden wird.

Erfindungemäß ist die Gaslanze mit dem Leitungsrohr und mit dem Verbindungselement durch eine Drehbewegung des Verbindungselements, der Gaslanze und/oder des Leitungsrohres verbindbar. Bevorzugt wird die Verbindung durch eine einfache Drehung des Verbindungselements bewirkt. Hierzu bilden die Gaslanze und das Leitungsrohr bzw. die Gaslanze, das Verbindungselement und das Leitungsrohr einen Bajonettverschluss.

Mit Bajonettverschluss ist eine Vorrichtung zum leicht lösbaren Verbinden zweier Teile in der Richtung ihrer Längsachse gemeint. Bei einem Bajonettverschluss besitzt der eine Teil, welcher über den andern geschoben wird, einen Längsschlitz, an dessen Ende sich rechtwinklig ein kurzer Querschlitz ansetzt. Der andere Teil besitzt dagegen einen Knopf, der in den Querschlitz eingeführt wird und dann die feste Verbindung bewirkt. Die Verbindung erfolgt über eine Steck-DrehBewegung: Die beiden zu verbindenden Teile werden ineinander gesetzt; annähernd senkrecht zur Steckrichtung sind in beiden Teilen an der Verbindungsstelle längliche Erhebungen angebracht. Diese laufen jedoch nicht rundum, sondern sind unterbrochen Da die Erhebungen nun leicht schräg in der Ebene senkrecht zur Steckrichtung liegen, werden durch eine Drehbewegung beide Teile gegeneinander gepresst. Der Bajonett-Verschluss arbeitet also ähnlich wie ein Gewinde. Vorteilhafterweise kann zur Sicherung der Verbindung zusätzlich eine Raste verwendet werden. Alternativ zum Verfahren der ineinander greifenden Schienen kann auch eine entsprechend geformte Einbuchtung am einen und eine Ausbuchtung am anderen Teil verwendet werden.

Der Vorteil eines Bajonettverschlusses liegt beispielsweise darin, dass die Verbindung zwischen Gaslanze und Leitungsrohr bzw. zwischen Gaslanze, Verbindungselement und Leitungsrohr durch eine einfache Drehbewegung mit einem Drehwinkel in einem Bereich von 1° bis 30°, insbesondere von 2° bis 15°, vorzugsweise von 3° bis 8°, insbesondere mit einem Drehwinkel von etwa 5°, hergestellt werden kann. Hierdurch kann auf einfache Weise eine gasdichte Durchführung zwischen der Gaslanze und dem Leitungsrohr hergestellt werden.

In einer weiteren Ausgestaltung weist das Verbindungselement ein Gewinde oder Gewindesegment für das Leitungsrohr auf, wobei vorteilhafterweise das Gewinde oder Gewindesegment einen Gewindesteigungswinkel im Bereich von 1° bis 15°, insbesondere von 3° bis 10°, vorzugsweise etwa 5°, aufweist. Bei der Verwendung eines Gewindesegments reicht eine Drehung des Verbindungselements um einen Winkel von weniger als 360° aus, um eine feste Verbindung zu bewirken.

In einer weiteren Ausgestaltung, die nicht zur Erfindung gehört, ist das Verbindungselement an einer Außenseite der Gaslanze befestigbar und als Haken, Klemmbügel oder Schelle ausgebildet. In dieser Ausgestaltung wird das Leitungsrohr formschlüssig und gasdicht mit der Gaslanze verbunden und die beiden Teile werden beispielsweise mit Hilfe eines Hakens, eines Klemmbügels oder einer Schelle zusammengepresst.

Das Verbindungselement kann formschlüssig und kraftschlüssig und gasdicht mit dem Prozessrohr verbindbar sein. Hierdurch wird ein Eintritt von Gas in das Innere des Prozessrohrs bzw. ein Austritt von im Prozessrohr befindlichen Gasen, die beispielsweise toxisch, entflammbar oder korrosiv sein können, verhindert.

Das Leitungsrohr ist geeignet und eingerichtet, insbesondere bestimmt, für die erfindungsgemäße gasdichte Durchführung. Das Leitungsrohr bildet einen wesentliches Teilstück der gasdichten Durchführung und wirkt im Zusammenspiel mit der Gaslanze für eine gasdichte Durchführung, die einerseits eine Dichtigkeit für das Prozessgas in dem Leitungsrohr und in der Gaslanze herstellt, andererseits das Prozessrohr nach außen zur Umgebungsatmosphäre abdichtet.

Die Gaslanze ist geeignet und eingerichtet, insbesondere bestimmt, für die erfindungsgemäße gasdichte Durchführung. Auch sie bildet ein Teilstück für die gasdichte Durchführung und bildet ein Gegenstück zu dem Leitungsrohr mit dem Verbindungselement. Sowohl das Leitungsrohr wie auch die Gaslanze weisen aufgrund ihres Zwecks, für eine gasdichte Durchführung für ein Prozessrohr in eine innerhalb des Prozessrohrs befindliche Prozesskammer zur Zu- bzw. Ableitung von Prozessgasen zu sorgen, eine besondere Hitzebeständigkeit und/oder besondere konstruktive Eigenschaften, beispielsweise Vorsprünge und/oder Aufnahmen zur Erzeugung einer gasdichten Verbindung auf.

Die erfindungsgemäße Anlage zum Abscheiden von Stoffen aus der Gasphase, insbesondere CVD - Anlage oder Diffusionsanlage, umfasst eine erfindungsgemäße gasdichte Durchführung. Vorteilhafterweise umfasst die Anlage zum Abscheiden von Stoffen aus der Gasphase, insbesondere CVD - Anlage oder Diffusionsanlage, einen Wasserdampferzeuger, der in fluidleitender Verbindung mit der gasdichten Durchführung steht.

Weitere Einzelheiten und vorteilhafte Ausgestaltungen werden anhand der folgenden Zeichnung, die einen Aspekt der Erfindung lediglich schematisch darstellen und nicht den Geist der Erfindung einschränken soll, näher erläutert. Es zeigen schematisch
- Fig. 1: eine erfindungsgemäße Anlage zum Abscheiden von Stoffen aus der Gas- phase, insbesondere CVD - Anlage, im Querschnitt;
- Fig. 2: eine erfindungsgemäße Gaslanze;
- Fig. 3: eine erfindungsgemäße gasdichte Durchführung im perspektivischen Querschnitt;
- Fig. 4: eine Explosionszeichnung eines Ausschnitts einer erfindungsgemäßen Gaslanze mit einem Verbindungselement;
- Fig. 5: die Gaslanze nach Fig. 4 mit einem Verbindungselement; und
- Fig. 6: eine Perspektivansicht nach Fig. 5.

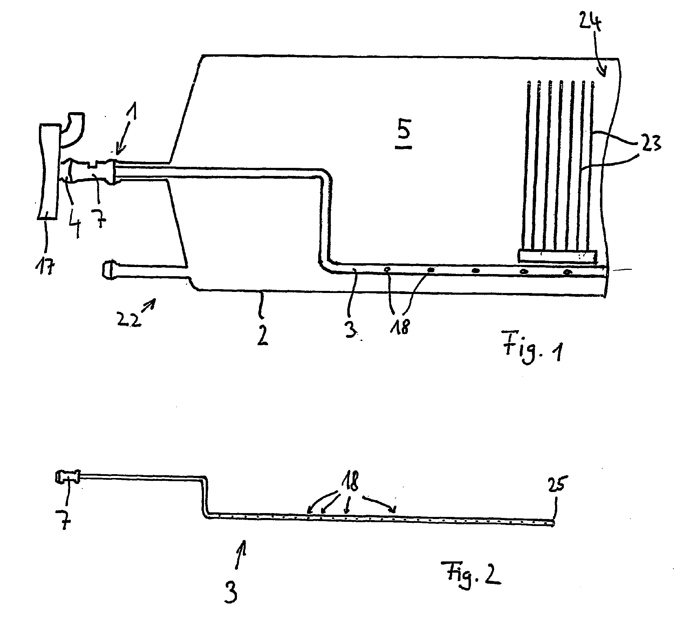

Fig. 1 zeigt eine erfindungsgemäße Anlage zum Abscheiden von Stoffen aus der Gasphase, insbesondere CVD - Anlage, umfassend ein Prozessrohr 2 und einen Wasserdampferzeuger 17, die mit Hilfe einer erfindungsgemäßen gasdichten Durchführung 1 miteinander verbunden sind. Im Inneren des Prozessrohrs 2 befindet sich eine Prozesskammer 5, in der eine Gaslanze 3 angeordnet ist. Die Gaslanze 3 wird mit einem Prozessgas, insbesondere Wasserdampf, beaufschlagt und gibt diesen mit Hilfe von Öffnungen 18 an die Prozesskammer 5 ab. In der Prozesskammer 5 befinden sich Werkstücke in Form von Wafern 23, die bedampft werden sollen, insbesondere deren Oberfläche passiviert und elektrisch isoliert werden sollen. Die Gaslanze 3 wird zur Zu- oder Ableitung von Prozessgasen durch das Prozessrohr 2 hindurch geführt, wozu ein Verbindungselement 7 für eine Abdichtung der Prozesskammer 5 und eine dichte Führung des Prozessgases nach außen bzw. von außen sorgt. Die Gaslanze 3 wird mit Hilfe des Verbindungselements 7 mit einem Leitungsrohr 4 verbunden, so dass ein Prozessgas von dem Wasserdampferzeuger 17 gasdicht bis zu den jeweiligen Öffnungen 18 geführt werden kann. Die Gaslanze 3 ist abgewinkelt und wird an einer Innenseite des Prozessrohrs 2 längs geführt. Die gewinkelte Gaslanze 3 ist vorzugsweise aus Quarz oder Siliziumcarbid gefertigt und wird durch eine Reaktoröffnung 24 eingeführt. Die Gaslanze 3 ist an ihrem freien Ende 25 geschlossen (s. Fig. 2). Das dem freien Ende 25 der Gaslanze 3 entgegengesetzte Ende besteht aus einem sich im Durchmesser verändernden Endstück, welches einen Dichtungsschliff 6 aufweist. Vorzugsweise wird ein konischer Schliff verwendet, es sind aber auch andere Geometrien möglich, z.B. eine Kugelgeometrie. In dem Bereich des sich verändernden Durchmessers ist weiterhin eine Bohrung 12 vorgesehen, die als Sackloch ausgebildet ist und somit nicht tiefer ist als die Wandstärke der Lanze.

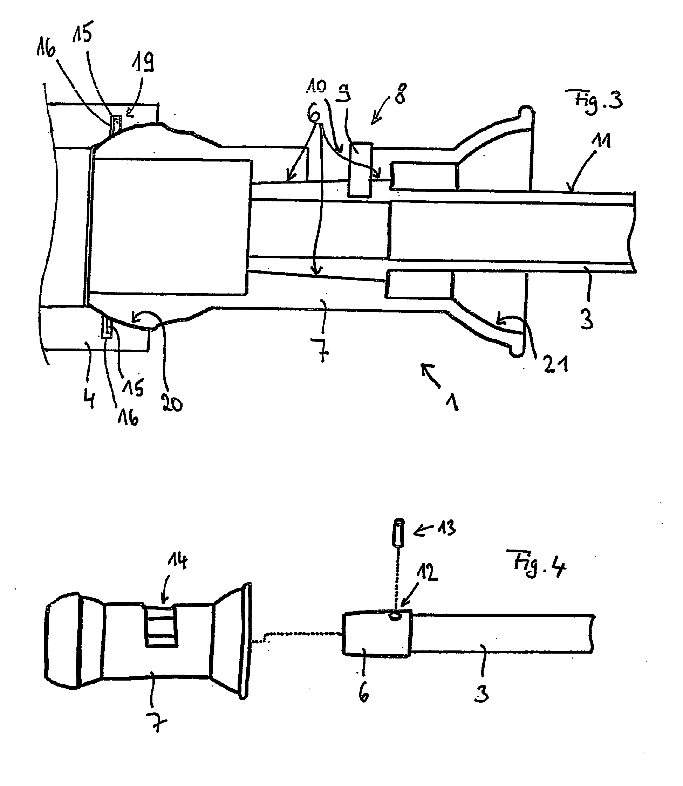

Fig. 3 zeigt die erfindungsgemäße gasdichte Durchführung im Querschnitt, wobei die Gaslanze 3 in das Verbindungselement 7 eingeschoben ist, so dass mit Hilfe eines Dichtungsschlitzes 6 eine Gasdichtigkeit entsteht. Die Gaslanze 3 und das Verbindungselement 7 sind durch einen Bajonettverschluss 8, der durch einen Vorsprung 9 und eine Aufnahme 10 gebildet ist, miteinander verbunden. Der Vorsprung 9 greift so in die Aufnahme 10, dass durch Drehung des Verbindungselements 7 die durch den Dichtungsschliff 6 vermittelte formschlüssige Verbindung zwischen Gaslanze 3 und Verbindungselement 7 zusammengedrückt wird. Hierzu ist die Aufnahme 10 als Schlitz ausgebildet, der gegenüber der Symmetrieachse des Verbindungselements 7 eine Gewindesteigung aufweist. Das Verbindungselement 7 weist einen zweiten Dichtungsschliff 20 zur Herstellung einer gasdichten Verbindung mit dem Leitungsrohr 4 auf, welches seinerseits eine entsprechende Gegenfläche aufweist. Das Leitungsrohr 4 und das Verbindungselement 7 sind durch einen zweiten Bajonettverschluss 19 miteinander gasdicht verbindbar. Der zweite Bajonettverschluss 19 wird durch einen zweiten Stift 15 und eine hierzu entsprechende Führungsnut 16 gebildet, wobei die Führungsnut 16 eine gewisse Steigung aufweist, um die beiden Teile 4 und 7 bei Drehung des Verbindungselements 7 aneinander zu pressen.

Fig. 4 zeigt eine Ausführungsform der erfindungsgemäßen Gaslanze 3 und des Verbindungselements 7 in Explosionsdarstellung, an der man erkennen kann, wie der Stift 13 in eine als Sackloch ausgeführte Bohrung 12 eingesteckt wird und die Gaslanze 3 mit dem Dichtungsschliff 6 in das Verbindungselement 7, welches einen Schlitz 14 aufweist, gesteckt werden kann. Hierzu weist das Verbindungselement 7 eine Nut für den Stift 13 auf, welcher entlang der Längsrichtung (Rotationsachse) des Verbindungselements 7 verläuft, so dass der Stift beim Zusammenstecken von Gaslanze 3 und Verbindungselement 7 in den Schlitz 14 geschoben werden kann.

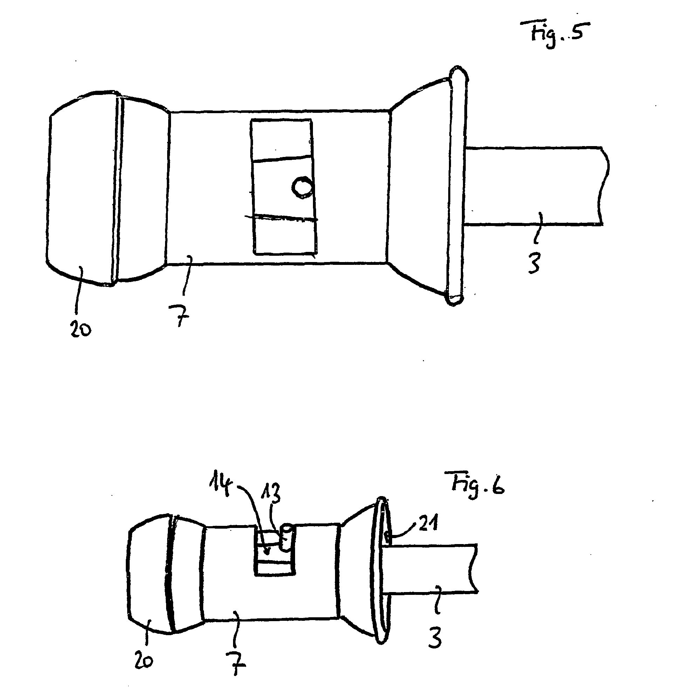

Fig. 5 und 6 zeigen Ansichten einer erfindungsgemäßen Ausführungsform der Gaslanze 3 in dem Verbindungselement 7. Das Verbindungselement 7 weist einen zweiten Dichtungsschliff 20 zur Verbindung mit einem Leitungsrohr (nicht dargestellt) und einen dritten Dichtungsschliff 21 zur Verbindung des Verbindungselements 7 mit dem Prozessrohr 2 auf.

### Bezugszeichenliste

- 1: Durchführung
- 2: Prozessrohr
- 3: Gaslanze
- 4: Leitungsrohr
- 5: Prozesskammer
- 6: Dichtungsschliff
- 7: Verbindungselement
- 8: Bajonettverschluss
- 9: Vorsprung
- 10: Aufnahme
- 11: Außenseite des Leitungsrohrs 4
- 12: Bohrung
- 13: Stift
- 14: Schlitz
- 15: zweiter Stift
- 16: Führungsnut
- 17: Wasserdampferzeuger
- 18: Öffnungen
- 19: zweiter Bajonettverschluss
- 20: zweiter Dichtungsschliff
- 21: dritter Dichtungsschliff
- 22: Anlage zum Abscheiden von Stoffen aus der Gasphase, insbesondere CVD - Anlage,
- 23: Wafer
- 24: Reaktoröffnung
- 25: freies Ende der Gasleitung 3

## Patentansprüche

1. Gasdichte Durchführung (1) für ein Prozessrohr (2) in eine innerhalb des Prozessrohres (2) befindliche Prozesskammer (5) zur Zu- und Ableitung von Prozessgasen, umfassend eine damit verbundenen insbesondere sich zumindest teilweise längs des Prozessrohres (2) innerhalb der Prozesskammer (5) erstreckende Gaslanze (3), ein Leitungsrohr (4) und ein Verbindungselement (7), welches an dem Leitungsrohr (4) und an der Gaslanze (3) befestigbar ist, wobei das Verbindungselement (7) mit der Gaslanze (3) und mit dem Leitungsrohr (4) jeweils formschlüssig und gasdicht verbunden ist und für einen Kraftschluss zwischen Gaslanze (3), Verbindungselement (7) und dem Leitungsrohr (4) sorgt, **dadurch gekennzeichnet, dass** die Gaslanze (3) oder das Verbindungselement (7) einen Vorsprung (9), vorzugsweise einen Stift (13) aufweist und dass das Verbindungselement (7) bzw. die Gaslanze (3) entsprechend hierzu eine Aufnahme (10), vorzugsweise eine Führungsnut oder einen Schlitz (14) mit Gewindesteigung, aufweist, so dass die Gaslanze (3) mit dem Verbindungselement (7) und mit dem Leitungsrohr (4) durch eine Drehbewegung des Verbindungselementes (7), der Gaslanze (3) und/oder des Leitungsrohres (4) verbindbar sind.

2. Gasdichte Durchführung (1) nach Anspruch 1, **dadurch gekennzeichnet, dass** mindestens ein Element aus der Gruppe Gaslanze (3), Leitungsrohr (4) und Verbindungselement (7) aus hitzebeständigem Material, insbesondere Glas, Keramik, Quarz, Siliziumkarbid, gefertigt ist.

3. Gasdichte Durchführung (1) nach Anspruch 1 oder 2, **dadurch gekennzeichnet, dass** mindestens ein Element aus der Gruppe Gaslanze (3), Leitungsrohr (4) und Verbindungselement (7) einen Dichtungsschliff (6), insbesondere einen Kugel- oder Kegelschliff, aufweist.

4. Gasdichte Durchführung (1) nach einem der Ansprüche 1 bis 3, **dadurch gekennzeichnet, dass** das Verbindungselement (7) ein Gewinde oder Gewindesegment für das Leitungsrohr (4) aufweist, wobei das Gewinde oder Gewindesegment einen Gewindesteigungswinkel im Bereich von 1° bis 15°, insbesondere von 3° bis 10°, aufweist.

5. Gasdichte Durchführung (1) nach einem der Ansprüche 1 bis 4, **dadurch gekennzeichnet, dass** das Verbindungselement (7) formschlüssig und kraftschlüssig und gasdicht mit dem Prozessrohr (2) verbindbar ist.

6. Gasdichte Durchführung (1) nach einem der Ansprüche 1 bis 5, **dadurch gekennzeichnet, dass** das Leitungsrohr (4) mit dem Verbindungselement (7) formschlüssig und kraftschlüssig und gasdicht mit dem Prozessrohr (2) verbindbar ist.

7. **[geändert]** Anlage zum Abscheiden von Stoffen aus der Gasphase, insbesondere CVD-Anlage oder Diffusionsanlage, **dadurch gekennzeichnet, dass** diese eine gasdichte Durchführung (1) nach einem der Ansprüche 1 bis 6 umfasst.

8. **[geändert]** Anlage zum Abscheiden von Stoffen aus der Gasphase, insbesondere CVD-Anlage oder Diffusionsanlage nach Anspruch 7, **dadurch gekennzeichnet, dass** diese einen Wasserdampferzeuger (20), der in fluidleitender Verbindung mit der gasdichten Durchführung (1) steht, umfasst.

## Claims

1. Gas-tight feed trough (1) for a process pipe (2) into a process chamber (5) located inside the process pipe (2) for supply and evacuation of process gases comprising a gas lance (3) and particularly extending inside the process chamber (5) at least partially along the process pipe (2), a conduit (4) and a connecting element (7), which is fixable to the conduit (4) and to the gas lance (3), wherein the connecting element (7) is form-fitted and gas-tightly connected with the gas lance (3) as well as with the conduit (4) and ensures the closed linkage between gas lance (3), connecting element (7) and conduit (4), **characterized by** the fact that the gas lance (3) or the connecting element (7) contains a nose (9), preferentially a pin (13), and that the connecting element (7) respectively the gas lance (3) contains a receptacle (10), preferentially a guide notch or a slot (14) with a thread pitch so that the gas lance (3) is combinable with the connecting element (7) and the conduit (4) by a rotary motion of the connecting element (7), the gas lance (3) and/or the conduit (4).

2. Gas-tight feed through (1) according to claim 1, **characterized by** the fact that at least one element out of the group of gas lance (3), conduit (4) and connecting element (7) is made of heat resistant material, in particular glass, ceramics, quartz, silicon carbide.

3. Gas-tight feed through (1) according to claim 1 or 2, **characterized by** the fact that at least one element out of the group of gas lance (3), conduit (4) and connecting element (7) contains a seal grinding section (6), in particular a spherical or a conic grinding section.

4. Gas-tight feed through (1) according to any of the claims 1 to 3, **characterized by** the fact that the connecting element (7) has a thread or a thread segment for the conduit (4), wherein the thread or the thread segment shows a thread pitch in the range of 1° to 15°, and particularly in the range of 3° to 10°.

5. Gas-tight feed through (1) according to any of the claims 1 to 4, **characterized by** the fact that the connecting element (7) is combinable form-fitted, friction-locked and gas-tight with the process pipe (2).

6. Gas-tight feed through (1) according to any of the claims 1 to 5, **characterized by** the fact that the conduit (4) together with the connecting element (7) is combinable friction-locked and gas-tight with the process pipe (2).

7. Equipment for the deposition of material from the vapor phase, in particular chemical vapor deposition (CVD) equipment or diffusion equipment, **characterized by** the fact that it comprises a gas-tight feed through (1) according to any of the claims 1 to 6.

8. Equipment for the deposition of material from the vapor phase, in particular chemical vapor deposition (CVD) equipment or diffusion equipment according to claim 7, **characterized by** the fact that it comprises a steam generator (20), which is in fluid-conductive contact to the gas-tight feed through (1).

## Revendications

1. Traversée étanche aux gaz (1) pour un tube de traitement (2) menant dans une chambre de traitement (5) qui se trouve à l'intérieur du tube de traitement (2) appropriée à l'introduction et à l'extraction des gaz de procédés, contenant une lance à gaz (3) fixée à la traversée et s'étendant au moins partiellement le long du tube de traitement (2) et spécialement à l'intérieur de la chambre de traitement (5), un tuyau de conduite (4) et un élément de raccordement (7), qui est fixable au tuyau de conduite (4) et à la lance à gaz (3), de manière que l'élément de raccordement (7) est lié, étanche aux gaz et à forme finale, à la lance à gaz (3) ainsi qu'au tuyau de conduite (4) et assure un raccord par adhérence entre la lance à gaz (3), l'élément de raccordement (7) et le tuyau de conduite (4), **caractérisé en ce que** la lance à gaz (3) ou l'élément de raccordement (7) comporte une saillie (9), de préférence une broche (13), et que l'élément de raccordement (7) ou la lance à gaz (3) comporte pour cela un élément de réception (10), de préférence une rainure de guidage ou une fente (14) avec un pas de vis, de sorte que la lance à gaz (3) soit connectable avec l'élément de raccordement (7) par un mouvement rotatif de l'élément de raccordement (7), de la lance à gaz (3) et/ou du tuyau de conduite (4).

2. Traversée étanche aux gaz (1) selon la revendication 1, **caractérisé en ce qu'**au moins un élément du groupe lance à gaz (3), tuyau de conduite (4) et élément de raccordement (7) soit fabriqué d'un matériau résistant à la chaleur, notamment le verre, la céramique, le quartz, le carbure de silicium.

3. Traversée étanche aux gaz (1) selon la revendication 1 ou 2, **caractérisé en ce qu'**au moins un élément du groupe lance à gaz (3), tuyau de conduite (4) et élément de raccordement (7) comporte un affûtage de joint (6), notamment un affûtage sphérique ou conique.

4. Traversée étanche aux gaz (1) selon l'une des revendications 1 à 3, **caractérisé en ce que** l'élément de raccordement (7) comporte un filetage ou un segment de filetage pour le tuyau de conduite (4), de manière que le filetage ou le segment de filetage comporte un pas de vis compris entre 1° et 15° et en particulier compris entre 3° et 10°.

5. Traversée étanche aux gaz (1) selon l'une des revendications 1 à 4, **caractérisé en ce que** l'élément de raccordement (7) est connectable à forme finale, étanchement aux gaz et assurant un raccord par adhérence avec le tube de traitement (2).

6. Traversée étanche aux gaz (1) selon l'une des revendications 1 à 5, **caractérisé en ce que** le tuyau de conduite (4) est connectable à forme finale avec l'élément de raccordement (7) et assurant un raccord par adhérence et étanche aux gaz avec le tube de traitement (2).

7. Installation destinée au dépôt des matières à partir de la phase vapeur, notamment une installation de dépôt chimique en phase vapeur (CVD) ou une installation de diffusion, **caractérisé en ce qu'**elle contient une traversée étanche aux gaz (1) selon l'une des revendications 1 à 6.

8. Installation destinée au dépôt des matières à partir de la phase vapeur, notamment une installation de dépôt chimique en phase vapeur (CVD) ou une installation de diffusion selon la revendication 7, **caractérisé en ce qu'**elle contient un générateur de vapeur (20) qui est en raccord conducteur à fluides avec la traversée étanche aux gaz (1).
